# EUROPEAN PATENT SPECIFICATION

(11) **EP 4 187 884 B1**
(45) Date of publication and mention of the grant of the patent: **25.06.2025**
(21) Application number: 21853840.3
(22) Date of filing: 08.07.2021
(51) Int. Cl.: H04M 1/02, H04M 1/18

(54) **DISPLAY WINDOW INCLUDING MULTIPLE PRINTED LAYERS AND ELECTRONIC DEVICE INCLUDING SAME**
ANZEIGEFENSTER MIT MEHREREN GEDRUCKTEN SCHICHTEN UND ELEKTRONISCHE VORRICHTUNG DAMIT
FENÊTRE D'AFFICHAGE COMPRENANT PLUSIEURS COUCHES IMPRIMÉES ET DISPOSITIF ÉLECTRONIQUE COMPRENANT CELLE-CI

(30) Priority: 04.08.2020 KR 20200097291
(43) Date of publication of application: 31.05.2023
(73) Proprietor: Samsung Electronics Co., Ltd., Suwon-si, Gyeonggi-do 16677 (KR)
(72) Inventor: OH, Dongjun, Suwon-si, Gyeonggi-do 16677 (KR); KIM, Byungsun, Suwon-si, Gyeonggi-do 16677 (KR); JUNG, Seungjae, Suwon-si, Gyeonggi-do 16677 (KR); KIM, Youdeuk, Suwon-si, Gyeonggi-do 16677 (KR)
(74) Representative: Gulde & Partner
(86) International application number: PCT/KR2021/008743
(87) International publication number: WO 2022/030778

(56) References cited:
- WO-A1-2018/117122
- JP-A- 2017 144 575
- KR-A- 20130 017 898
- KR-A- 20130 069 220
- KR-A- 20150 019 251
- KR-A- 20160 028 595
- KR-A- 20160 083 310
- US-A1- 2020 014 415

## Description

### [Technical Field]

The invention generally relates to a display window including a plurality of printed layers improved in bonding strength and an electronic device including the same.

### [Background Art]

In the case of display windows included in most current electronic devices, in order to prevent exposure of internal objects (displays, FPCBs, etc.), shield print may be applied on a border area except for the visually necessary light emitting screen. The ink used for shield print may have a color similar to or the same as the display, and the shield print may be applied through various printing methods such as silk printing.

In order to prevent abrasion or damage of a printed paint film due to frequent contact by the user, shield print is applied on the rear surface of the window with reference to the user. However, since various internal component and/or external fixtures are attached to the rear surface of the window, the shield print area requires high bonding strength in order to fix such internal/external components. In addition, it is necessary for the shield print area to be able to protect the internal/external components from water and dust entering from the outside (e.g., waterproof and dustproof).
WO 2018/117122 A1 discloses an electronic device having a conventionally designed board with two printed layers stacked, where one layer is stacked over another.

### [Disclosure of Invention]

### [Technical Problem]

The print area of the display window may generally be configured in a multi-layer structure. That is, since it is difficult to implement a sufficient printing thickness to secure functions such as color implementation, shielding, and paint film durability with a single paint film, a multi-printing process may be applied to the print area.

However, a dye or a pigment added to a printing resin to implement a color may act as a factor in reducing a bonding property to a printing object (i.e., an adherend member). In particular, the use of a first printing layer (first ink layer) to be directly attached to a display window may be limited due to a problem in bonding strength. In addition, there is a problem in that the commercial value of the electronic device may be damaged because a print peeling phenomenon due to an external impact (e.g., drop impact) may easily occur due to a decrease in bonding strength.

In view of the above-mentioned disadvantages, an object of the present disclosure is to provide an electronic device that improve the bonding strength of a printed paint film through a stack structure of printed layers of a display window improved in bonding strength.

### [Technical Solution]

The present invention is defined by the appended set of claims. An electronic device according to an embodiment may include: a housing configuring at least a portion of an exterior of the electronic device; a display module mounted on the housing; a transparent plate configuring at least a portion of a front surface of the electronic device and fixed to the housing; and a paint film covering a partial area including an edge of the transparent plate. The transparent plate may include a first surface facing the front surface, a second surface facing an opposite direction to the first surface, and a third surface interconnecting the first surface and the second surface and surrounding the transparent plate. The paint film may include: a first printed layer covering a first region of the second surface and at least a portion of the third surface of the transparent plate; a second printed layer stacked on the first printed layer, the second printed layer covering a second area of the second surface that is wider than the first area; and a third printed layer stacked on the second printed layer, the third printed layer covering a third area of the second surface narrower than the second area.

The solution according to the invention can be further improved by the embodiments mentioned in the dependent claims.

### [Advantageous Effects of Invention]

According to various embodiments disclosed herein, by reducing the content of a dye or a pigment contained in the first printed layer of a print area of a display window, it is possible to improve the bonding strength of the print area and the durability of the paint film.

According to various embodiments disclosed herein, in the structure in which a plurality of printed layers are stacked in a display window, by performing printing such that the area in which the second printed layer covers the window is wider than the area in which the first printed layer covers the window, it is possible to solve problems such as poor exterior and a vision recognition error caused by reducing the content of a dye or a pigment contained in the first printed layer, and to implement the color of the entire print area.

In addition to this, various effects identified directly or indirectly through this document may be provided.

### [Brief Description of Drawings]

The invention is described hereinafter in more detail and in an exemplary manner using advantageous embodiments and with reference to the drawings. The described embodiments are only possible configurations in which, however, the individual features as describes above can be provided independent of one another or can be omitted in the drawings:

For elements of an exemplary embodiment, which correspond in form and/or function to elements of another exemplary embodiment, the same reference numerals are used.
FIG. 1A is a front side perspective view of a mobile electronic device according to an embodiment.
FIG. 1B is a rear side perspective view of the electronic device of FIG. 1A.
FIG. 1C is an exploded perspective view of the electronic device of FIG. 1A.
FIG. 2 is a view illustrating a transparent plate structure on the front surface of an electronic device according to an exemplary embodiment and a print area peeling-off phenomenon due to an external impact.
FIG. 3 is a view illustrating a print area of a transparent plate of an electronic device according to an embodiment.
FIG. 4 is a design view illustrating a structure in which a plurality of printed layers are stacked in a print area of a transparent plate of an electronic device according to an embodiment.
FIG. 5 is a graph showing a change in optical density according to the content ratio of a black pigment.
FIG. 6 is a view illustrating a structure in which a plurality of printed layers are actually stacked in a print area of a transparent plate of an electronic device according to an embodiment.
FIGS. 7A to 7C are design views each illustrating a structure in which a plurality of printed layers are stacked on a side surface portion of a transparent plate according to various embodiments.
FIG. 8 is a view illustrating a transparent plate and internal/external components bonded to a transparent plate of an electronic device according to an embodiment.

In connection with the description of the drawings, the same or similar components may be denoted by the same or similar reference numerals.

### [Mode for Carrying out the Invention]

Hereinafter, various embodiments disclosed herein will be described with reference to the accompanying drawings. The sizes of elements illustrated in the drawings may be exaggerated or reduced for the convenience of description, and the disclosure is not necessarily limited by the illustrated sizes.

The electronic device according to various embodiments disclosed herein may be one of various types of electronic devices. The electronic devices may include, for example, a portable communication device (e.g., a smart phone), a computer device, a portable multimedia device, a portable medical device, a camera, a wearable device, or a home appliance. The electronic device according to embodiments of the disclosure is not limited to those described above.

It should be appreciated that various embodiments of the disclosure and the terms used therein are not intended to limit the technological features set forth herein to particular embodiments and include various changes, equivalents, or alternatives for a corresponding embodiment. With regard to the description of the drawings, similar reference numerals may be used to designate similar or relevant elements. A singular form of a noun corresponding to an item may include one or more of the items, unless the relevant context clearly indicates otherwise. As used herein, each of such phrases as "A or B," "at least one of A and B," "at least one of A or B," "A, B, or C," "at least one of A, B, and C," and "at least one of A, B, or C" may include all possible combinations of the items enumerated together in a corresponding one of the phrases. As used herein, such terms as "a first", "a second", "the first", and "the second" may be used to simply distinguish a corresponding element from another, and does not limit the elements in other aspect (e.g., importance or order). It is to be understood that if an element (e.g., a first element) is referred to, with or without the term "operatively" or "communicatively", as "coupled with/to" or "connected with/to" another element (e.g., a second element), it means that the element may be coupled/connected with/to the other element directly (e.g., wiredly), wirelessly, or via a third element.

As used herein, the term "module" may include a unit implemented in hardware, software, or firmware, and may be interchangeably used with other terms, for example, "logic," "logic block," "component," or "circuit". The "module" may be a minimum unit of a single integrated component adapted to perform one or more functions, or a part thereof. For example, according to an embodiment, the "module" may be implemented in the form of an application-specific integrated circuit (ASIC).

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., Play StoreTM), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each element (e.g., a module or a program) of the above-described elements may include a single entity or multiple entities, and some of the multiple entities may be separately disposed in any other element. According to various embodiments, one or more of the above-described elements may be omitted, or one or more other elements may be added. Alternatively or additionally, a plurality of elements (e.g., modules or programs) may be integrated into a single element. In such a case, according to various embodiments, the integrated element may still perform one or more functions of each of the plurality of elements in the same or similar manner as they are performed by a corresponding one of the plurality of elements before the integration. According to various embodiments, operations performed by the module, the program, or another element may be carried out sequentially, in parallel, repeatedly, or heuristically, or one or more of the operations may be executed in a different order or omitted, or one or more other operations may be added.

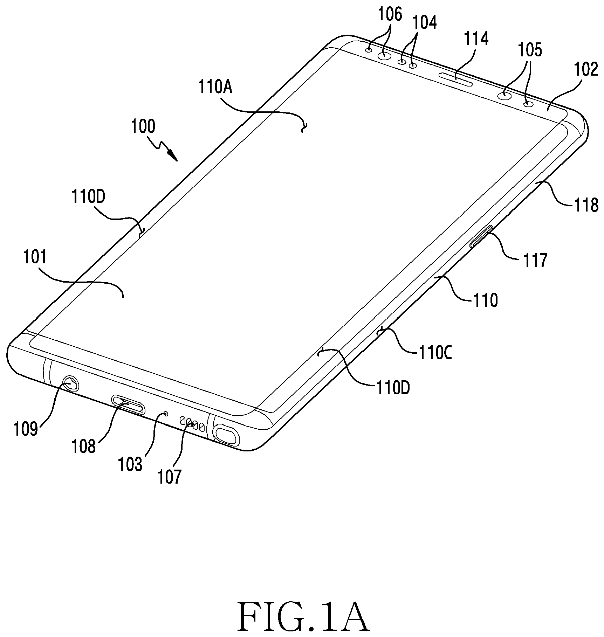

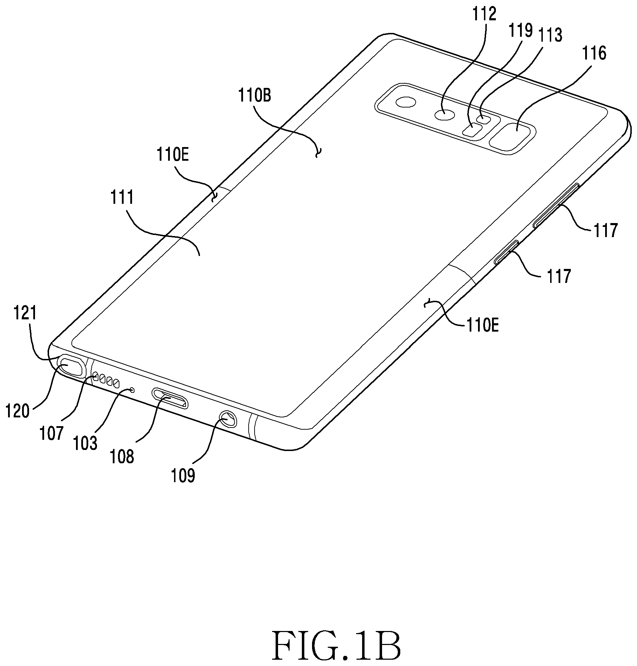

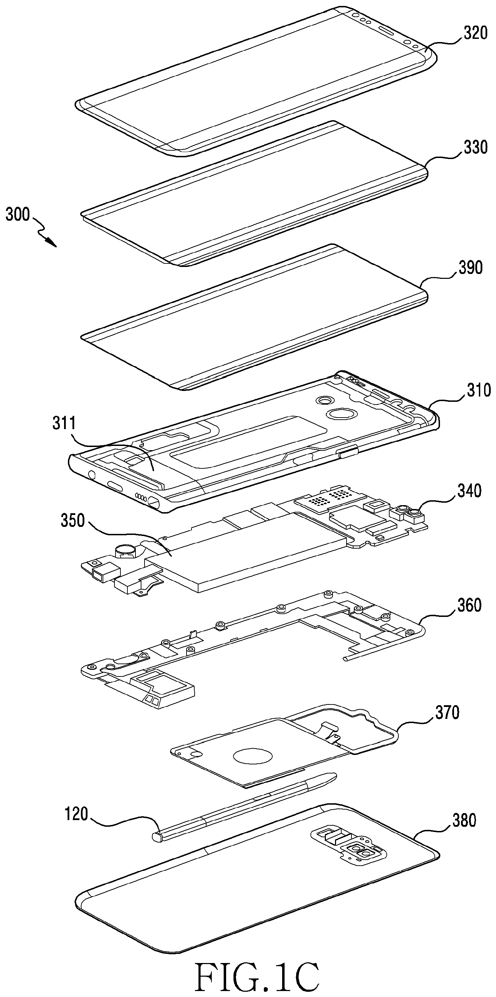

FIG. 1A is a front side perspective view of a mobile electronic device according to an embodiment, FIG. 1B is a rear side perspective view of the electronic device of FIG. 1A, and FIG. 1C is an exploded perspective view of the electronic device of FIG. 1A.

Referring to FIGS. 1A and 1B, an electronic device 100 according to an embodiment may include: a housing 110 including a first surface (or a front surface) 110A, a second surface (or a rear surface) 110B, and a side surface 110C surrounding a space between the first surface 110A and the second surface 110B. In another embodiment (not illustrated), the housing may refer to a structure providing some of the first surface 110A, the second surface 110B, and the side surface 110C of FIG. 1A. According to an embodiment, the first surface 110A may be at least partially configured with a substantially transparent front plate 102 (e.g., a glass plate or a polymer plate including various coating layers). The second surface 110B may be configured with a substantially opaque rear surface plate 111. The rear surface plate 111 may be made of, for example, coated or colored glass, ceramic, polymer, metal (e.g., aluminum, stainless steel (STS), or magnesium), or a combination of two or more of these materials. The side surface 110C may be configured with a side surface bezel structure (or a "side surface member") 118 coupled to the front surface plate 102 and the rear surface plate 111 and including metal and/or polymer. In some embodiments, the rear surface plate 111 and the side surface bezel structure 118 may be integrally configured, and may include the same material (e.g., a metal material such as aluminum).

In the illustrated embodiment, the front surface plate 102 may include two first areas 110D, which are bent from the first surface 110A toward the rear surface plate 111 and extend seamlessly, at the long opposite side edges thereof. In the illustrated embodiment (see FIG. 1B), the rear surface plate 111 may include two second areas 110E, which are bent from the second surface 110B toward the front surface plate 102 and extend seamlessly, at the long opposite side edges thereof. In some embodiments, the front surface plate 102 (or the rear surface plate 111) may include only one of the first areas 110D (or the second areas 110E). In another embodiment, some of the first areas 110D or the second areas 110E may not be included. In the above-described embodiments, when viewed from a side of the electronic device 100, the side surface bezel structure 118 may have a first thickness (or width) on the side in which the first areas 110D or the second areas 110E are not included, and may have a second thickness, which is thinner than the first thickness, on the side in which the first areas 110D or the second areas 110E are included.

According to an embodiment, the electronic device 100 may include one or more of a display 101, audio modules 103, 107, and 114, sensor modules 104, 116, and 119, camera modules 105, 112, and 113, key input devices 117, a light-emitting element 106, a pen input device 120, and connector holes 108 and 109. In some embodiments, at least one of the components (e.g., the key input devices 117 or the light-emitting elements 106) may be omitted from the electronic device 100, or the electronic device 100 may additionally include other components.

The display 101 may be exposed through, for example, a substantial portion of the front surface plate 102. In some embodiments, at least a portion of the display 101 may be exposed through the front surface plate 102 providing the first surface 110A and the first areas 110D of the side surface 110C. In some embodiments, the edges of the display 101 may be formed to be substantially the same as the shape the periphery of the front surface plate 102 adjacent thereto. In another embodiment (not illustrated), the distance between the periphery of the display 101 and the periphery of the front surface plate 102 may be substantially constant in order to enlarge the exposed area of the display 101.

In another embodiment (not illustrated), recesses or openings may be provided in a portion of a screen display area of the display 101, and at least one of an audio module 114, a sensor module 104, a camera module 105, and a light-emitting element 106, which are aligned with the recesses or the openings, may be included. In another embodiment (not illustrated), the rear surface of the screen display area of the display 101 may include at least one of the audio module 114, the sensor module 104, the camera module 105, the fingerprint sensor 116, and the light-emitting element 106. In another embodiment (not illustrated), the display 101 may be coupled to or disposed adjacent to a touch-sensitive circuit, a pressure sensor capable of measuring a touch intensity (pressure), and/or a digitizer configured to detect an electromagnetic field-type stylus pen. In some embodiments, at least some of the sensor modules 104 and 119 and/or at least some of the key input devices 117 may be disposed in the first areas 110D and/or the second areas 110E.

The audio modules 103, 107, and 114 may include a microphone hole 103 and speaker holes 107 and 114. The microphone hole 103 may include a microphone disposed therein so as to acquire external sound, and in some embodiments, multiple microphones may be disposed therein so as to detect the direction of sound. The speaker holes 107 and 114 may include an external speaker hole 107 and a call receiver hole 114. In some embodiments, the speaker holes 107 and 114 and the microphone hole 103 may be implemented as a single hole, or a speaker may be included without the speaker holes 107 and 114 (e.g., a piezo speaker).

The sensor modules 104, 116, and 119 may generate electrical signals or data values corresponding to the internal operating state or the external environmental state of the electronic device 100. The sensor modules 104, 116, and 119 may include, for example, a first sensor module 104 (e.g., a proximity sensor) and/or a second sensor module (not illustrated) (e.g., a fingerprint sensor) disposed on the first surface 110A of the housing 110, and/or a third sensor module 119 (e.g., an HRM sensor) and/or a fourth sensor module 116 (e.g., a fingerprint sensor) disposed on the second surface 110B of the housing 110. The fingerprint sensor may be disposed not only on the first surface 110A of the housing 110 (e.g., the display 101), but also on the second surface 110B. The electronic device 100 may further include at least one of sensor modules (not illustrated), such as a gesture sensor, a gyro sensor, an atmospheric pressure sensor, a magnetic sensor, an acceleration sensor, a grip sensor, a color sensor, an infrared (IR) sensor, a biometric sensor, a temperature sensor, a humidity sensor, or an illuminance sensor.

The camera modules 105, 112, and 113 may include a first camera device 105 disposed on the first surface 110A of the electronic device 100, and a second camera device 112 and/or a flash 113 disposed on the second surface 110B of the electronic device 100. The camera devices 105 and 112 may include one or more lenses, an image sensor, and/or an image signal processor. The flash 113 may include, for example, a light-emitting diode or a xenon lamp. In some embodiments, two or more lenses (e.g., an infrared camera lens, a wide-angle lens, and a telephoto lens) and image sensors may be disposed on one surface of the electronic device 100.

The key input devices 117 may be disposed on the side surface 110C of the housing 110. In another embodiment, the electronic device 100 may not include some or all of the above-mentioned key input devices 117, and a key input device 117, which is not included, may be implemented in another form, such as a soft key, on the display 101. In some embodiments, the key input devices may include a sensor module 116 disposed on the second surface 110B of the housing 110.

The light-emitting element 106 may be disposed, for example, on the first surface 110A of the housing 110. The light-emitting elements 106 may provide, for example, the state information of the electronic device 100 in an optical form. In another embodiment, the light-emitting element 106 may provide a light source that is interlocked with, for example, the operation of the camera module 105. The light-emitting elements 106 may include, for example, an LED, an IR LED, and a xenon lamp.

The connector holes 108 and 109 may include a first connector hole 108, which is capable of accommodating a connector (e.g., a USB connector) for transmitting/receiving power and/or data to/from an external electronic device, and/or a second connector hole (e.g., an earphone jack) 109, which is capable of accommodating a connector for transmitting/receiving an audio signal to/from an external electronic device.

The pen input device 120 (e.g., a stylus pen) may be guided to be inserted into or detached from the inside of the housing 110 through a hole 121 provided in the side surface of the housing 110, and may include a button for facilitating the detachment. The pen input device 120 may include a separate resonance circuit therein to be interlocked with an electromagnetic induction panel 390 (e.g., a digitizer) included in the electronic device 100. The pen input device 120 may include an electromagnetic resonance (EMR) scheme, an active electrical stylus (AES) scheme, and an electric coupled resonance (ECR) scheme.

Referring to FIG. 1C, the electronic device 300 may include a side surface bezel structure 310, a first support member 311 (e.g., a bracket), a front surface plate 320, a display 330, an electromagnetic induction panel 390, a printed circuit board 340, a battery 350, a second support member 360 (e.g., a rear case), an antenna 370, a pen input device 120, and a rear surface plate 380. In some embodiments, at least one of the components (e.g., the first support member 311 or the second support member 360) may be omitted from the electronic device 300, or other components may be additionally included in the electronic device 101. At least one of the components of the electronic device 300 may be the same as or similar to at least one of the components of the electronic device 100 of FIG. 1A or FIG. 1B, and a redundant description thereof is omitted below.

The electromagnetic induction panel 390 (e.g., a digitizer) may be a panel configured to detect the input of the pen input device 120. For example, the electromagnetic induction panel 390 may include a printed circuit board (e.g., a flexible printed circuit board (FPCB)) and a shield sheet. The shield sheet is capable of preventing interference between components (e.g., a display module, a printed circuit board, an electromagnetic induction panel, etc.) included in the electronic device 100 due to electromagnetic fields generated from the components. By blocking the electromagnetic fields generated from the components, the shield sheet is capable of causing an input from the pen input device 120 to be accurately transmitted to a coil included in the electromagnetic induction panel 390. The electromagnetic induction panel 390 according to various embodiments may include an opening provided in at least an area corresponding to a biometric sensor mounted on the electronic device 100.

The first support member 311 may be disposed inside the electronic device 300 to be connected to the side surface bezel structure 310, or may be configured integrally with the side surface bezel structure 310. The first support member 311 may be formed of, for example, a metal material and/or a non-metal (e.g., polymer) material. The first support member 311 may have one surface to which the display 330 is coupled, and the other surface to which the printed circuit board 340 is coupled. A processor, memory, and/or interface may be mounted on the printed circuit board 340. The processor may include one or more of, for example, a central processing unit, an application processor, a graphics processor, an image signal processor, a sensor hub processor, or a communication processor.

The memory may include, for example, volatile memory or non-volatile memory.

The interface may include, for example, a high-definition multimedia interface (HDMI), a universal serial bus (USB) interface, an SD card interface, and/or an audio interface. For example, the interface may electrically or physically connect the electronic device 300 with an external electronic device, and may include a USB connector, an SD card/MMC connector, or an audio connector.

The battery 350 is a device for supplying power to at least one component of the electronic device 300, and may include, for example, a non-rechargeable primary battery, a rechargeable secondary battery, or a fuel cell. At least a portion of the battery 350 may be disposed on substantially the same plane as, for example, the printed circuit board 340. The battery 350 may be integrally disposed inside the electronic device 300, or may be detachably disposed on the electronic device 300.

The antenna 370 may be disposed between the rear surface plate 380 and the battery 350. The antenna 370 may include, for example, a near-field communication (NFC) antenna, a wireless charging antenna, and/or a magnetic secure transmission (MST) antenna. For example, the antenna 370 may execute short-range communication with an external device, or may transmit/receive power required for charging to/from the external device in a wireless manner. In another embodiment, an antenna structure may be configured by a portion of the side surface bezel structure 310 and/or the first support member 311, or a combination thereof.

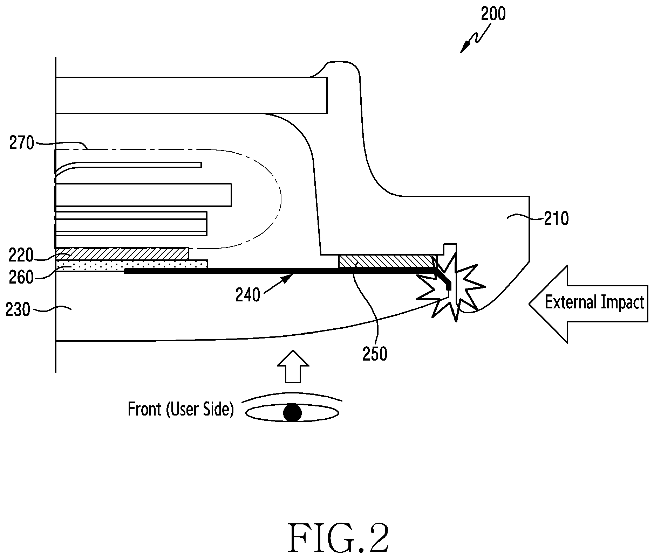

FIG. 2 illustrates the structure of a transparent plate 230 on the front surface of an electronic device 200 (e.g., the electronic device 100 in FIG. 1A or the electronic device 300 in FIG. 1C) according to an embodiment and a peeling phenomenon of a print area 240 caused by an external impact.

Referring to FIG. 2, an electronic device 200 according to an embodiment includes a housing 210 configuring at least a portion of the exterior of the electronic device 200, a display module 220 seated on the housing 210, and a transparent plate 230 configuring at least a portion of the front surface of the electronic device 200 and fixed by the housing 210, and various circuits 270 required for driving the electronic device 200 may be disposed inside the housing 200 of the electronic device 200. The circuits 270 may include, for example, a processor, memory, a sensor module, an antenna module, and the like, which may be disposed on a flexible printed circuit board (FPCB) and electrically connected to each other.

According to an embodiment, the display module 220 may visually provide various contents output from the electronic device 200 to the user. A transparent plate 230 (or a window for a display) is disposed on the front surface of the electronic device 200 to prevent internal components of the electronic device 200 (including the display module 220) from being exposed to the outside, and the transparent plate 230 disposed on the front surface may be made of a transparent material so as not to disturb a screen output from the display. According to an embodiment, as the transparent material, a material having sufficient strength to protect the display module 220 and the circuits 270 of the electronic device 200, such as tempered glass, polymethyl methacrylate (PMMA), may be used.

According to an embodiment, an adhesive member 250 may be used to fix the transparent plate 230 to the housing 210, and an optical adhesive member 260 may be used to fix the transparent plate 230 to the display module 220. According to an embodiment, as the adhesive member 250, tape or bond may be used, and as the optical adhesive member 260, an optically clear adhesive (OCA) and/or an optically clear resin (OCR) may be used. However, without being limited thereto, various materials having an adhesive property may be used.

According to an embodiment, in order to prevent unnecessary exposure of the internal components of the electronic device 200 to the outside and to ensure aesthetic appearance, shield print may be applied to the edge area of the transparent plate 230. That is, the shield print may be applied to the border area of the display module 220 except for the light-emitting screen that is visually necessary, and the area to which the shield print has been applied may be referred to as a print area 240. According to an embodiment, the print area 240 may be coated with an ink color-matched to be the same as or similar to the color of the display module 220. The print area 240 according to an embodiment may be printed through a plurality of (e.g., three) printing processes in order to implement the color of the print area 240 and secure durability of the paint film. Accordingly, the print area 240 may include a plurality of printed layers.

According to an embodiment, in order to prevent abrasion or damage of the printed paint film due to frequent contact by the user, shield print may be applied to the rear surface of the transparent plate 230 (that is, the surface facing the opposite direction to the front surface of the electronic device 200) with reference to the user's gaze. According to an embodiment, the shield printing may be applied to the rear surface of the transparent plate 230 and a portion of the side surface of the transparent plate 230 connected to the rear surface. Since the print area 240 may be peeled off due to an external impact, sufficient bonding strength to the transparent plate 230 may be required to prevent peeling and secure commercial value.

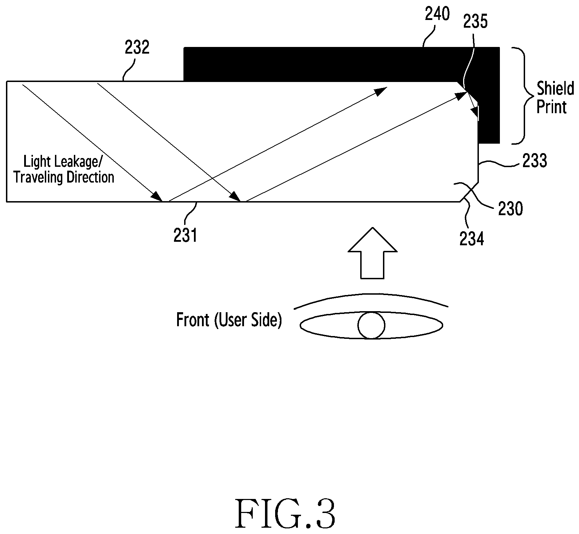

FIG. 3 is a view illustrating the print area 240 of the transparent plate 230 of the electronic device 200 according to an exemplary embodiment.

Referring to FIG. 3, the transparent plate 230 includes a first surface 231 facing the front surface of the electronic device 200, a second surface 232 facing the opposite direction to the first surface 231, and a third surface 233 surrounding the transparent plate 230 while connecting the first surface 231 and the second surface 232. According to an embodiment, the transparent plate 230 may further include a surface 234 interconnecting the first surface 231 and the third surface 233 and/or a surface 235 interconnecting the second surface 232 and the third surface 233. However, the shape of the transparent plate 230 is not limited thereto. FIG. 3 illustrates that the first surface 231, the third surface 233, and the surface 234 interconnecting the first surface 231 and the third surface 233 are connected to each other while forming an angle to each other, and the second surface 232, the third surface 233, and the surface 235 interconnecting the second surface 232 and the third surface 233 are connected to each other while forming an angle to each other. However, the shape of the transparent plate 230 is not limited thereto, and the above-mentioned surfaces may be connected to each other in a round shape without forming an angle.

According to an embodiment, light emitted from the display module 220 may be reflected inside the transparent plate 230 and leaked to the third surface 233 (i.e., the side surface) of the transparent plate 230, which may deteriorate the aesthetics of the exterior of the electronic device 200. According to an embodiment, in order to prevent light emission (or light leakage) from the side surface, shield print may be applied not only to the edge area of the transparent plate 230, but also to a partial area of the third surface 233 connected to the edge. Accordingly, the print area 240 may include a printed paint film in the edge area of the second surface 232 for preventing exposure of internal components and a printed paint film in the partial area of the third surface 233 connected to the edge area.

In the case of the print area 240, in particular, in the case of the area printed on the third surface 233 of the transparent plate 230, sufficient bonding strength to the transparent plate 230 is required since the area may be peeled off due to friction with the housing 210 during the assembly of the electronic device 200, and may be peeled off by an external impact or by an external foreign substance after the assembly of the electronic device 200. However, in the conventional case, since a dye or a pigment contained in the ink used for printing reduces the adhesiveness of a printed layer, a first printed layer 241 of the print area 240 may be printed only on the second surface 232 and printing of the first printed layer 241 on the third surface 233 may be limited. Hereinafter, a stack structure and a material content ratio of printed layers of the disclosure for improving the bonding strength of the print area 240 will be described.

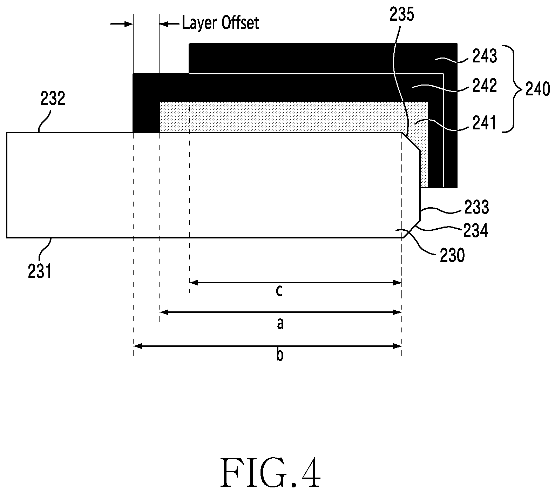

FIG. 4 is a design view illustrating a structure in which a plurality of printed layers are stacked in the print area 240 of the transparent plate 230 of the electronic device 200 according to an embodiment.

Referring to FIG. 4, the print area 240 includes a first printed layer (first ink layer) 241 directly covering the transparent plate 230, a second printed layer 242 (second ink layer) stacked on the first printed layer 241, and a third printed layer 243 (third ink layer) stacked on the second printed layer 242. According to an embodiment, the first printed layer 241 overlaps a first area a of the first surface 231 when viewing the transparent plate 230 from the front side, the second printed layer 242 overlaps a second area b wider than the first area a of the first surface 231 when viewing the transparent plate 230 from the front side, and the third printed layer 243 overlaps a third area c narrower than the second area b of the first surface 231 when viewing the transparent plate 230 from the front side. Preferably, the third area c of the first surface 231 may be narrower than the first area a.

According to an embodiment, the length of the width of the second printed layer 242 applied on the transparent plate 230 may be longer than the length of the width of the first printed layer 241 applied on the transparent plate 230. In addition, the length of the width of the third printed layer 243 applied on the transparent plate 230 may be shorter than the length of the width of the first printed layer 241 applied on the transparent plate 230.

According to an embodiment, the first printed layer 241, the second printed layer 242, and the third printed layer 243 (or the inks used for the first printed layer 241, the second printed layer 242, and the third printed layer 243) may include at least one of a resin, a dye, a pigment, and various additives. According to an embodiment, a dye and/or a pigment may implement the color of the printed layers, and generally a black dye and/or a black pigment may be used. However, without being limited thereto, a dye and/or a pigment having a color corresponding to the color of the display module 220 may be used. According to an embodiment, an additive may prevent the aggregation of dye or pigment and improve the degree of application of ink to an adherend surface.

According to an embodiment, a dye, a pigment, and/or an additive included in the resin may reduce the bonding strength of a printed layer to a print target (i.e., an adherend member). Accordingly, in the present disclosure, when the first printed layer 241 is directly printed on the transparent plate 230 having poor bonding strength, the content of a dye and/or a pigment contained in the resin may be reduced.

However, when a dye and/or a pigment are completely excluded from the first printed layer 241, it may be difficult to recognize the first printed layer 241 in an automatic inspection machine that inspects the dimension or exterior of a printed layer by using a vision recognition (or an image recognition and vision inspection) function. That is, when the first printed layer 241 is completely transparent, it is impossible to identify whether printing is suitable in the inspection process performed using the vision recognition function, and even if there is splashing of ink, the splashing is not be found, so a defect may occur after display lamination. Accordingly, the content of the dye and/or the pigment contained in the first printed layer 241 may be reduced as much as possible, but the minimum amount of the dye and/or the pigment sufficient to identify whether printing is defective may be used. According to an embodiment, the first printed layer 241 may be translucent, and the mixing ratio of a color ink including the dye and/or the pigment contained in the first printed layer 241 may be 1% to 15%. Preferably, the mixing ratio of the color ink including the dye and/or the pigment contained in the first printed layer 241 may be 3% to 7%.

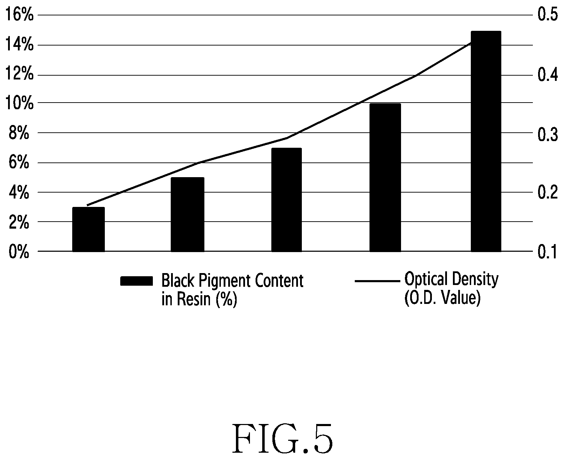

FIG. 5 is a graph showing a change in optical density according to the content ratio of a black pigment.

Referring to FIG. 5, higher the content ratio of the black pigment, higher the optical density (O.D.). Here, the optical density is a negative common logarithmic value of the rate at which light passes through a sample when light is flashed on the sample. When the optical density is 0, the color is completely transparent, and the higher the optical density, the darker the color.

According to an embodiment, in the case of the first printed layer 241, a color ink containing a dye and/or a pigment having a mixing ratio of 1 to 15%, and preferably, a color ink containing a dye and/or a pigment having a mixing ratio of 3 to 7%, may be used. Referring to the graph of FIG. 5, when the mixing ratio of the colored ink including a dye and/or a pigment is 3 to 7%, the optical density value may be 0.1 to 0.24, and when the optical density is 0.1 to 0.24, the optical density may be at a level that is minimally recognizable by vision recognition equipment. That is, when the first printed layer 241 is printed by using a color ink containing a dye and/or a pigment having a mixing ratio of 1 to 15%, it may be possible to secure the minimum visibility that is capable of being recognized by vision recognition equipment.

According to an embodiment, the mixing ratio (e.g., 1 to 15%) of the color ink containing a dye and/or a pigment contained in the first printed layer 241 may be lower than the mixing ratio (e.g., 9 to 13%) of the color link containing a dye and/or a pigment contained in the second printed layer 242 or the third printed layer 243. Accordingly, the first printed layer 241 may have higher bonding strength than the second printed layer 242 and/or the third printed layer 243, and may be printed on the third surface 233 as well as the second surface 232 of the transparent plate 230.

Referring back to FIG. 4, the second printed layer 242 is stacked on the first printed layer 241. According to an embodiment, an area larger than the area covered with the first printed layer 241 on the second surface 232 of the transparent plate 230 is covered with the second printed layer 242. That is, the second printed layer 242 may be printed so as to cause the first printed layer 241 to be reversely offset-printed beyond the area of the transparent plate 230 covered by the first printed layer 241. When the area printed with the second printed layer 242 on the transparent plate 230 is designed to be smaller than the area printed with the first printed layer 241 (i.e., a positive offset), the first printed layer 241 may be visible outside the second printed layer 242. Thus, a band shape may occur on the front surface of the transparent plate 230, and the aesthetics of the front surface of the electronic device 200 may be impaired. In addition, when the first printed layer 241 is visible outside the second printed layer 242, misrecognition may be caused in vision recognition equipment due to a difference in optical density between the first printed layer 241 and the second printed layer 242. Therefore, when an area larger than the area printed with the first printed layer 241 on the second surface 232 of the transparent plate 230 is printed with the second printed layer 242, it is possible to solve the above-described problems and to make the opaque (or faint) first printed layer 241 invisible on the front surface of the electronic device 200.

According to an embodiment, a third printed layer 243 is stacked on the second printed layer 242. According to an embodiment, an area narrower than the area covered with the second printed layer 242 on the second surface 232 of the transparent plate 230 is covered with the third printed layer 243. That is, in order to prevent the second printed layer 242 from being printed beyond the area covering the transparent plate 230, the third printed layer 243 may be positively offset-printed in a step pattern.

According to an embodiment, the first printed layer 241 initially printed on the second surface 232 of the transparent plate 230 may implement a primer function and improve a bonding property so that the second printed layer 242 may be smoothly printed. According to an embodiment, the second printed layer 242 stacked on the first printed layer 241 may have a color implementation function, and may implement a color corresponding to the color of the display module 220 by adjusting the mixing ratio of the color ink containing a dye and/or a pigment contained in the second printed layer 242. According to an embodiment, the third printed layer 243 stacked on the second printed layer 242 may implement bonding performance to adherend components (e.g., the housing 210 and the display module 220) to be attached to the print area 240.

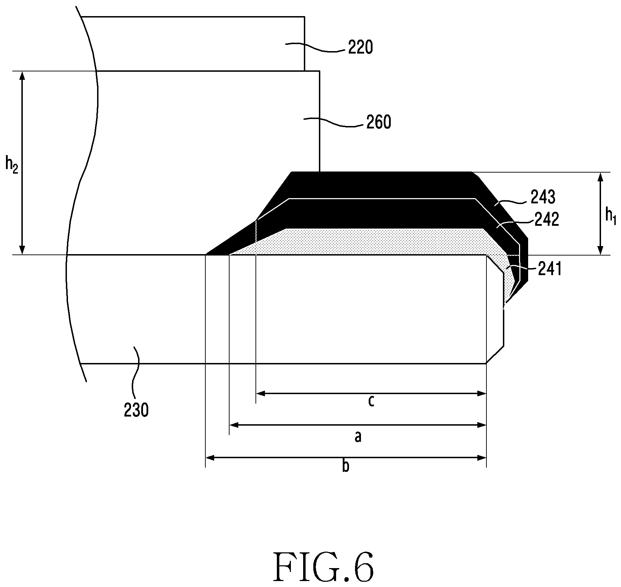

An actual structure in which the first printed layer 241, the second printed layer 242, and the third printed layer 243 are stacked in the print area 240 and specific dimensions thereof will be described with reference to FIG. 6 below.

FIG. 6 is a view illustrating a structure in which a plurality of printed layers are actually stacked in a print area 240 of a transparent plate 230 of an electronic device 200 according to an embodiment.

According to an embodiment, as illustrated in FIG. 4, when a stack structure of the print area 240 (or the first to third printed layers 241 to 243) is designed and actually printed on the transparent plate 230, the stack structure in FIG. 6 may be obtained. That is, when the first to third printed layers 241 to 243 are actually printed, both end portions of each printed layer may be printed to be thinner than the thickness of the central portion (or initially intended printing thickness).

According to an embodiment, due to the characteristics of the printed structure of the second printed layer 242 that is reversely offset-printed, air traps may be easily generated or burst to generate air bubbles at the end portions of the second printed layer 242 located on the second surface 232, but this problem may be solved by improving process conditions. For example, this problem may be solved by adjusting the viscosity of the ink used in the printed layers or adjusting the printing speed.

According to an embodiment, due to a characteristic of the print structure of the second printed layer 242 which is reversely offset-printed, it is difficult for the end portions of the second printed layer 242 located on the second side 232 and the adjacent portions thereof to secure a print thickness, which may cause a problem in the durability of the print area 240, but this problem may be solved by attaching the optical adhesive member 260. That is, since the end portions of the second printed layer 242 located on the second surface 232 are areas that are laminated with the display module 220, even when the print thickness of the second printed layer is relatively thin, the second printed layer may secure durability by being supported by the bonding strength of the thick optical adhesive member 260.

According to an embodiment, the optical adhesive member 260, which bonds the transparent plate 230 to the display module 220 may be bonded to at least a portion of the second printed layer 242 and the third printed layer 243. Alternatively, the optical adhesive member 260 may be bonded only to at least a portion of the second printed layer 242 without being bonded to the third printed layer 243. The thickness h₂ of the optical adhesive member 260 may be greater than the thickness h₁ of the print area 240. For example, the thickness h₁ of the print area 240 in which the first printed layer 241, the second printed layer 242, and the third printed layer 243 are stacked may be 10 to 20 µm, and the thickness h₂ of the optical adhesive member 260 may be 100 to 150 µm.

According to an embodiment, the width b of the second printed layer 242 printed on the second surface 232 of the transparent plate 230 may be longer than the width a of the first printed layer 241 printed on the second surface 232. For example, the width b of the second printed layer 242 printed on the second surface 232 of the transparent plate 230 may be longer than the width a of the first printed layer 241 printed on the second surface 232 by 0.1 to 0.3 mm from the edge of the transparent plate 230. According to an embodiment, the width c of the third printed layer 243 printed on the second surface 232 of the transparent plate 230 may be shorter than the width b of the second printed layer 242 printed on the second surface 232. According to an embodiment, the width c of the third printed layer 243 printed on the second surface 232 of the transparent plate 230 may be shorter than the width a of the first printed layer 241 printed on the second surface 232.

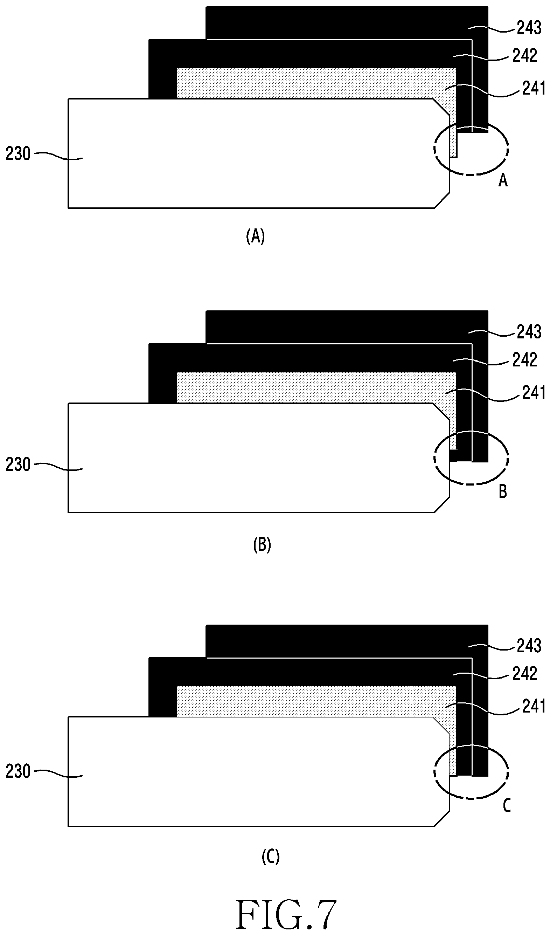

FIGS. 7A to 7C are design views each illustrating a structure in which a plurality of printed layers are stacked on a side surface portion of the transparent plate 230 according to various embodiments.

According to an embodiment, the printed form of the first to third printed layers 241 to 243 on the side surface (i.e., the third surface 233) of the transparent plate 230 may vary. FIG. 7A illustrates an embodiment in which the second printed layer 242 and the third printed layer 243 are printed inside the first printed layer 241 in a positive offset form, FIG. 7B illustrates an embodiment in which the second printed layer 242 and the third printed layer 243 are printed outside the first printed layer 241 in a reverse offset form, and FIG. 7C illustrates an embodiment in which the second printed layer 242 and the third printed layer 243 are printed such that the ends thereof are aligned with the end of the first printed layer 241 without offset.

That is, the form in which the first to third printed layers 241 to 243 are printed on the third surface 233 of the transparent plate 230 is not limited to any of the above-mentioned ones, and may be applied in various ways. According to another embodiment, the second printed layer 242 and/or the third printed layer 243 may be printed not only on the third surface 233 of the transparent plate 230, but also up to a corner portion near the first surface 231.

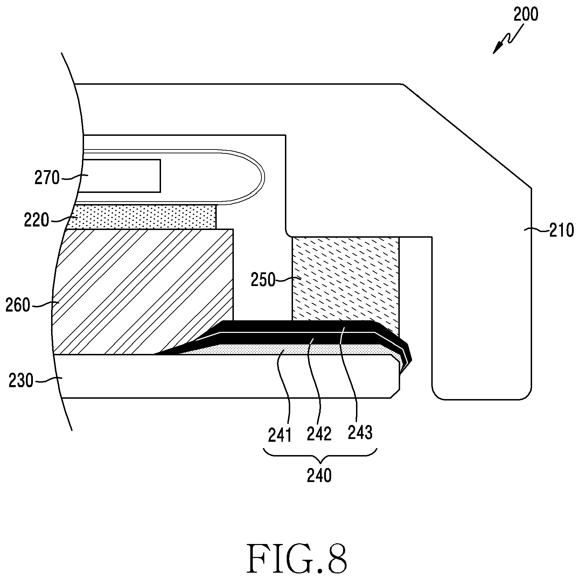

Referring to FIG. 8, the structure of the transparent plate 230 and the print area 240 printed on the transparent plate 230 will be described once again from the viewpoint of the entire electronic device 200.

FIG. 8 is a view illustrating the transparent plate 230 of the electronic device 200 and internal/external components bonded to the transparent plate 230 according to an embodiment.

Referring to FIG. 8, the housing 210 of the electronic device 200 configures at least a portion of the exterior of the electronic device 200, and the transparent plate 230 (or the display window) of the electronic device 200 configures at least a portion of a front surface of the electronic device 200. According to an embodiment, the transparent plate 230 may be seated on the housing 210, and a display module 220 and various circuit components 270 may be disposed in an inner empty space of the electronic device 200 surrounded by the housing 210 and the transparent plate 230. For example, the display module 220 may be located adjacent to the transparent plate 230.

According to an embodiment, a print layer 240 printed with an ink containing a resin, a dye, a pigment, and/or an additive may be located in an edge area of the rear surface of the transparent plate 230 (that is, an area adjacent to the housing 210), and the print area 240 includes a plurality of printed layers.

According to an embodiment, the first printed layer 241 may directly cover portions of the second surface 232 and the third surface 233 of the transparent plate 230. According to an embodiment, the second printed layer 242 is stacked on the first printed layer 241 to cover portions of the second surface 232 and the third surface 233 of the transparent plate 230. The second printed layer 242 is printed over a wider area including the area in which the first printed layer 241 is printed on the second surface 232 of the transparent plate 230. According to an embodiment, the third printed layer 243 is stacked on the second printed layer 242 to cover portions of the second surface 232 and the third surface 233 of the transparent plate 230. The third printed layer 243 is printed to be narrower than the area in which the second printed layer 242 is printed on the second surface 232 of the transparent plate 230.

According to an embodiment, the adhesive member 250 may bond the transparent plate 230 to the housing 210, and may be bonded to at least a portion of the third printed layer 243 in the vicinity of one end of the third printed layer 243. According to an embodiment, the optical adhesive member 260 may bond the transparent plate 230 to the display module 220, and may be bonded to at least portions of the second printed layer 242 and the third printed layer 243 in the vicinity of the end opposite to the one end of the third printed layer 243.

According to an embodiment, the adhesive member 250 may be bonded to the third printed layer 243 and may not be directly bonded to the transparent plate 230. According to an embodiment, the optical adhesive member 260 may be directly bonded not only to the second printed layer 242 and the third printed layer 243, but also to at least a portion of the second surface 232 of the transparent plate 230 adjacent to an end of the second printed layer 242. The optical adhesive member 260 may completely cover end portions of the first printed layer 241, the second printed layer 242, and the third printed layer 243 that are thinly printed. That is, the optical adhesive member 260 may be bonded to the print area 240 to exceed an end portion of the thin print area 240.

As described above, an electronic device (e.g., the electronic device 200 in FIG. 2) according to an embodiment may include: a housing configuring at least a portion of an exterior of the electronic device; a display module mounted on the housing; a transparent plate configuring at least a portion of a front surface of the electronic device and fixed to the housing; and a paint film covering a partial area including an edge of the transparent plate. The transparent plate may include a first surface facing the front surface, a second surface facing an opposite direction to the first surface, and a third surface interconnecting the first surface and the second surface and surrounding the transparent plate. The paint film may include: a first printed layer covering a first area of the second surface and at least a portion of the third surface of the transparent plate; a second printed layer stacked on the first printed layer, the second printed layer covering a second area of the second surface that is wider than the first area; and a third printed layer stacked on the second printed layer, the third printed layer covering a third area of the second surface narrower than the second area.

According to an embodiment, the first printed layer may have higher bonding strength than the second printed layer and the third printed layer.

According to an embodiment, the electronic device may further include a first adhesive member configured to bond the transparent plate to the housing, and the first adhesive member may be bonded to at least a portion of the third printed layer.

According to an embodiment, the electronic device may further include a second adhesive member configured to bond the transparent plate to the display module, and the second adhesive member may be bonded to at least a portion of the second printed layer and the third printed layer.

According to an embodiment, the first printed layer, the second printed layer, and the third printed layer may include at least one of a resin, a dye, a pigment, and an additive.

According to an embodiment, the first printed layer is translucent, and the content of the dye or the pigment contained in the first printed layer may be 3 to 7%.

According to an embodiment, the width of the second area may be longer than the width of the first area by 0.1 to 0.3 mm from the edge of the transparent plate.

According to an embodiment, the third area may be narrower than the first area.

According to an embodiment, the color of the second printed layer or the third printed layer corresponds to the color of the display module.

According to an embodiment, the second printed layer and the third printed layer may cover a portion of the second surface and at least a portion of the third surface.

According to an embodiment, the second printed layer and the third printed layer may block light emitted from the third surface of the transparent plate.

According to an embodiment, the first printed layer may include a primer function, the second printed layer may include a color implementation function, and the third printed layer may include a bonding function.

According to an embodiment, the stacked thickness of the first printed layer, the second printed layer, and the third printed layer is 10 µm to 20 µm.

As described above, a display window (e.g., the transparent plate 230 in FIG. 2 ) of an electronic device (e.g., the electronic device 200 in FIG. 2) according to an embodiment configures at least a portion of the front surface of the electronic device, and may include a first surface facing the front surface, a second surface facing the opposite direction to the first surface, and a third surface interconnecting the first surface and the second surface and surrounding the display window. A partial area including an edge of the display window may be covered with a plurality of printed layers, and the plurality of printed layers may include: a first printed layer covering a portion of the second surface and a portion of the third surface of the display window, the first printed layer overlapping a first area of the first surface when viewing the display window from a front side; a second printed layer stacked on the first printed layer, the second printed layer overlapping a second area of the first surface wider than the first area when viewing the display window from the front side; and a third printed layer stacked on the second printed layer, the third printed layer overlapping a third area of the first surface narrower than the second area when viewing the display window from the front side.

According to an embodiment, the first printed layer may have higher bonding strength than the second printed layer and the third printed layer.

According to an embodiment, at least a portion of the second printed layer or the third printed layer may be bonded to a housing or the display module of the electronic device.

According to an embodiment, the first printed layer, the second printed layer, and the third printed layer may include at least one of a resin, a dye, a pigment, and an additive, and the content of the dye or the pigment contained in the first printed layer may be 3 to 7%.

According to an embodiment, the width of the second area may be longer than the width of the first area by 0.1 to 0.3 mm from the edge of the display window.

According to an embodiment, the second printed layer and the third printed layer may cover a portion of the second surface and a portion of the third surface, and the second printed layer and the third printed layer may block light emitted from the third surface of the display window.

According to an embodiment, the first printed layer may include a primer function, the second printed layer may include a color implementation function, and the third printed layer may include a bonding function.

While the disclosure has been shown and described with reference to exemplary embodiments thereof, it will be apparent to the skilled person that various changes in form and detail may be made thereto without departing from the scope of the disclosure as defined by the following claims.

## Claims

1. An electronic device comprising:
a housing (210) configuring at least a portion of an exterior of the electronic device;
a display module (220) mounted on the housing (210);
a transparent plate (230) configuring at least a portion of a front surface of the electronic device and fixed to the housing (210); and
a paint film (240) covering a partial area comprising an edge of the transparent plate,
wherein the transparent plate (230) comprises a first surface (231) facing the front surface, a second surface (232) facing an opposite direction to the first surface, and a third surface (233) interconnecting the first surface (231) and the second surface (232) and surrounding the transparent plate, and
wherein the paint film (240) comprises:
a first printed layer (241) covering a first area (a) of the second surface (232) and at least a portion of the third surface (233) of the transparent plate (230); and
a second printed layer (242) stacked on the first printed layer (241),
**characterized in that**,
the second printed layer (242) covers a second area (b) of the second surface (232) that is wider than the first area (a); and
a third printed layer (243) is stacked on the second printed layer (242), the third printed layer (243) covering a third area (c) of the second surface (232) narrower than the second area (b).

2. The electronic device of claim 1, wherein the first printed layer (241) has higher bonding strength than the second printed layer (242) and the third printed layer (243).

3. The electronic device of any of claims 1 to 2, further comprising a first adhesive member (250) configured to bond the transparent plate (230) to the housing (210),
wherein the first adhesive member (250) is bonded to at least a portion of the third printed layer (243).

4. The electronic device of any of claims 1 to 3, further comprising a second adhesive member (260) configured to bond the transparent plate (230) to the display module (220),
wherein the second adhesive member (260) is bonded to at least a portion of the second printed layer (242) and the third printed layer (243).

5. The electronic device of any of claims 1 to 4, wherein the first printed layer (241), the second printed layer (242), and the third printed layer (243) comprise at least one of a resin, a dye, a pigment, and an additive.

6. The electronic device of claim 5, wherein the first printed layer (241) is translucent, and a content of the dye or the pigment contained in the first printed layer (241) is 3 to 7%.

7. The electronic device of any of claims 1 to 6, wherein a width of the second area (b) is longer than a width of the first area (a) by 0.1 to 0.3 mm from an edge of the transparent plate (230).

8. The electronic device of any of claims 1 to 7, wherein the third area (c) is narrower than the first area (a).

9. The electronic device of any of claims 1 to 8, wherein a color of the second printed layer (242) or the third printed layer (243) corresponds to a color of the display module (220).

10. The electronic device of any of claims 1 to 9, wherein the second printed layer (242) and the third printed layer (243) cover a portion of the second surface (232) and at least a portion of the third surface (233).

11. The electronic device of any of claims 1 to 10, wherein the second printed layer (242) and the third printed layer (243) block light emitted from the third surface (233) of the transparent plate (230).

12. The electronic device of any of claims 1 to 11, wherein the first printed layer (241) comprises a primer function, the second printed layer (242) comprises a color implementation function, and the third printed layer (243) comprises a bonding function.

13. The electronic device of any of claims 1 to 12, wherein a stacked thickness of the first printed layer (241), the second printed layer (242), and the third printed layer (243) is 10 µm to 20 µm.

## Patentansprüche

1. Elektronische Vorrichtung, umfassend:
ein Gehäuse (210), das mindestens einen Abschnitt einer Außenseite der elektronischen Vorrichtung konfiguriert;
ein Anzeigemodul (220), das auf dem Gehäuse (210) montiert ist;
eine transparente Platte (230), die mindestens einen Abschnitt einer vorderen Fläche der elektronischen Vorrichtung konfiguriert und an dem Gehäuse (210) befestigt ist; und
eine Farbschicht (240), die einen Teilbereich abdeckt, der einen Rand der transparenten Platte umfasst,
wobei die transparente Platte (230) eine erste Fläche (231), die der vorderen Platte zugewandt ist, eine zweite Fläche (232), die der ersten Fläche in entgegengesetzter Richtung zugewandt ist, und eine dritte Fläche (233) umfasst, die die erste Fläche (231) und die zweite Fläche (232) miteinander verbindet und die transparente Platte umgibt, und
wobei die Farbschicht (240) umfasst:
eine erste gedruckte Schicht (241), die einen ersten Bereich (a) der zweiten Fläche (232) und mindestens einen Abschnitt der dritten Fläche (233) der transparenten Platte (230) bedeckt; und
eine zweite gedruckte Schicht (242), die auf die erste gedruckte Schicht (241) gestapelt ist,
**dadurch gekennzeichnet, dass**
die zweite gedruckte Schicht (242) einen zweiten Bereich (b) der zweiten Fläche (232) abdeckt, der breiter ist als der erste Bereich (a); und
eine dritte gedruckte Schicht (243) auf die zweite gedruckte Schicht (242) gestapelt ist, wobei die dritte gedruckte Schicht (243) einen dritten Bereich (c) der zweiten Fläche (232) abdeckt, der schmaler ist als der zweite Bereich (b).

2. Elektronische Vorrichtung nach Anspruch 1, wobei die erste gedruckte Schicht (241) eine höhere Bindungsstärke aufweist als die zweite gedruckte Schicht (242) und die dritte gedruckte Schicht (243).

3. Elektronische Vorrichtung nach einem der Ansprüche 1 bis 2, ferner umfassend ein erstes Klebeelement (250), das konfiguriert ist, um die transparente Platte (230) mit dem Gehäuse (210) zu verbinden,
wobei das erste Klebeelement (250) mit mindestens einem Abschnitt der dritten gedruckten Schicht (243) verbunden ist.

4. Elektronische Vorrichtung nach einem der Ansprüche 1 bis 3, ferner umfassend ein zweites Klebeelement (260), das konfiguriert ist, um die transparente Platte (230) mit dem Anzeigemodul (220) zu verbinden,
wobei das zweite Klebeelement (260) mit mindestens einem Abschnitt der zweiten gedruckten Schicht (242) und der dritten gedruckten Schicht (243) verbunden ist.

5. Elektronische Vorrichtung nach einem der Ansprüche 1 bis 4, wobei die erste gedruckte Schicht (241), die zweite gedruckte Schicht (242) und die dritte gedruckte Schicht (243) mindestens eines von einem Harz, einem Farbstoff, einem Pigment und einem Additiv umfassen.

6. Elektronische Vorrichtung nach Anspruch 5, wobei die erste gedruckte Schicht (241) lichtdurchlässig ist und ein Gehalt des Farbstoffs oder des Pigments, der/das in der ersten gedruckten Schicht (241) enthalten ist, 3 bis 7 % beträgt.

7. Elektronische Vorrichtung nach einem der Ansprüche 1 bis 6, wobei eine Breite des zweiten Bereichs (b) um 0,1 bis 0,3 mm von einem Rand der transparenten Platte (230) länger ist als eine Breite des ersten Bereichs (a).

8. Elektronische Vorrichtung nach einem der Ansprüche 1 bis 7, wobei der dritte Bereich (c) schmaler ist als der erste Bereich (a).

9. Elektronische Vorrichtung nach einem der Ansprüche 1 bis 8, wobei eine Farbe der zweiten gedruckten Schicht (242) oder der dritten gedruckten Schicht (243) mit einer Farbe des Anzeigemoduls (220) übereinstimmt.

10. Elektronische Vorrichtung nach einem der Ansprüche 1 bis 9, wobei die zweite gedruckte Schicht (242) und die dritte gedruckte Schicht (243) einen Abschnitt der zweiten Fläche (232) und mindestens einen Abschnitt der dritten Fläche (233) abdecken.

11. Elektronische Vorrichtung nach einem der Ansprüche 1 bis 10, wobei die zweite gedruckte Schicht (242) und die dritte gedruckte Schicht (243) Licht blockieren, das von der dritten Fläche (233) der transparenten Platte (230) emittiert wird.

12. Elektronische Vorrichtung nach einem der Ansprüche 1 bis 11, wobei die erste gedruckte Schicht (241) eine Grundierungsfunktion umfasst, die zweite gedruckte Schicht (242) eine Farbumsetzungsfunktion umfasst und die dritte gedruckte Schicht (243) eine Verbindungsfunktion umfasst.

13. Elektronische Vorrichtung nach einem der Ansprüche 1 bis 12, wobei eine Stapeldicke der ersten gedruckten Schicht (241), der zweiten gedruckten Schicht (242) und der dritten gedruckten Schicht (243) 10 µm bis 20 µm beträgt.

## Revendications

1. Dispositif électronique, comprenant :
un boîtier (210) configurant au moins une partie d'un extérieur du dispositif électronique ;
un module d'affichage (220) monté sur le boîtier (210) ;
une plaque transparente (230) configurant au moins une partie d'une surface frontale du dispositif électronique et fixée au boîtier (210) ; et
un film de peinture (240) couvrant une zone partielle comprenant un bord de la plaque transparente,
dans lequel la plaque transparente (230) comprend une première surface (231) faisant face à la surface frontale, une deuxième surface (232) faisant face à une direction opposée à la première surface, et une troisième surface (233) reliant la première surface (231) et la deuxième surface (232) et entourant la plaque transparente, et
dans lequel le film de peinture (240) comprend :
une première couche imprimée (241) couvrant une première zone (a) de la seconde surface (232) et au moins une partie de la troisième surface (233) de la plaque transparente (230) ; et
une seconde couche imprimée (242) empilée sur la première couche imprimée (241),
**caractérisé en ce que**
la seconde couche imprimée (242) couvre une seconde zone (b) de la seconde surface (232) qui est plus large que la première zone (a) ; et
une troisième couche imprimée (243) est empilée sur la deuxième couche imprimée (242), la troisième couche imprimée (243) couvrant une troisième zone (c) de la deuxième surface (232) plus étroite que la deuxième zone (b).

2. Dispositif électronique de la revendication 1, dans lequel la première couche imprimée (241) présente une force de liaison plus élevée que la seconde couche imprimée (242) et la troisième couche imprimée (243).

3. Dispositif électronique de l'une quelconque des revendications 1 à 2, comprenant en outre un premier élément adhésif (250) configuré pour lier la plaque transparente (230) au boîtier (210),
dans lequel le premier élément adhésif (250) est lié à au moins une partie de la troisième couche imprimée (243).

4. Dispositif électronique de l'une quelconque des revendications 1 à 3, comprenant en outre un second élément adhésif (260) configuré pour lier la plaque transparente (230) au module d'affichage (220),
dans lequel le second élément adhésif (260) est lié à au moins une partie de la seconde couche imprimée (242) et de la troisième couche imprimée (243).

5. Dispositif électronique de l'une quelconque des revendications 1 à 4, dans lequel la première couche imprimée (241), la seconde couche imprimée (242), et la troisième couche imprimée (243) comprennent au moins l'un d'une résine, d'un colorant, d'un pigment et d'un additif.

6. Dispositif électronique de la revendication 5, dans lequel la première couche imprimée (241) est translucide, et une teneur en colorant ou en pigment contenue dans la première couche imprimée (241) est de 3 à 7 %.

7. Dispositif électronique de l'une quelconque des revendications 1 à 6, dans lequel une largeur de la seconde zone (b) est plus longue qu'une largeur de la première zone (a) de 0,1 à 0,3 mm à partir d'un bord de la plaque transparente (230).

8. Dispositif électronique de l'une quelconque des revendications 1 à 7, dans lequel la troisième zone (c) est plus étroite que la première zone (a).

9. Dispositif électronique de l'une quelconque des revendications 1 à 8, dans lequel une couleur de la seconde couche imprimée (242) ou de la troisième couche imprimée (243) correspond à une couleur du module d'affichage (220).

10. Dispositif électronique de l'une quelconque des revendications 1 à 9, dans lequel la deuxième couche imprimée (242) et la troisième couche imprimée (243) recouvrent une partie de la deuxième surface (232) et au moins une partie de la troisième surface (233).

11. Dispositif électronique de l'une quelconque des revendications 1 à 10, dans lequel la seconde couche imprimée (242) et la troisième couche imprimée (243) bloquent la lumière émise par la troisième surface (233) de la plaque transparente (230).

12. Dispositif électronique de l'une quelconque des revendications 1 à 11, dans lequel la première couche imprimée (241) comprend une fonction de fond, la seconde couche imprimée (242) comprend une fonction de mise en œuvre des couleurs, et la troisième couche imprimée (243) comprend une fonction de collage.

13. Dispositif électronique de l'une quelconque des revendications 1 à 12, dans lequel une épaisseur empilée de la première couche imprimée (241), de la seconde couche imprimée (242) et de la troisième couche imprimée (243) est comprise entre 10 µm et 20 µm.
